Europäisches Patentamt

(19) European Patent Office

Office européen des brevets

(11) **EP 0 841 701 A1**

(12) **EUROPEAN PATENT APPLICATION**

(43) Date of publication:
**13.05.1998 Bulletin 1998/20**

(51) Int. Cl.$^6$: **H01L 27/08**, G01R 31/316

(21) Application number: **97119272.9**

(22) Date of filing: **04.11.1997**

(84) Designated Contracting States:
**AT BE CH DE DK ES FI FR GB GR IE IT LI LU MC NL PT SE**
Designated Extension States:
**AL LT LV MK RO SI**

(30) Priority: **06.11.1996 JP 310171/96**

(71) Applicant: **YOZAN INC.**
**Tokyo 155 (JP)**

(72) Inventors:
• **Shou, Guoliang**
**Tokyo 155 (JP)**

• **Motohashi, Kazunori**
**Tokyo 155 (JP)**
• **Yamamoto, Makoto**
**Tokyo 155 (JP)**

(74) Representative:
**Grünecker, Kinkeldey,**
**Stockmair & Schwanhäusser**
**Anwaltssozietät**
**Maximilianstrasse 58**
**80538 München (DE)**

(54) **Component characteristics measurement circuit in an integrated semiconductor circuit system**

(57) The present invention provides a circuit enable to measure the component characteristics deviation of an integrated semiconductor circuit system. It has the structure that an input impedance and a feedback impedance are connected to an inverting amplifying circuit consisting of an odd number of stages of inverters. Enough impedance units are connected to make one of them the reference impedance and another the measurement object, known voltage is input to the inverting amplifying circuit, and its output is measured from the outside of the integrated semiconductor circuit system.

FIG. 1

EP 0 841 701 A1

## Description

### FIELD OF THE INVENTION

The present invention relates to a component characteristics measurement circuit in an integrated semiconductor circuit system.

### BACKGROUND OF THE INVENTION

The inventor proposes various analog integrated semiconductor circuit systems. In Japanese Patent Laid-Open publication No. 7-95947 (the first conventional embodiment), a linear inverting amplifying circuit with an odd number of serial inverters was proposed, with its output connected to its input through a feedback capacitor, this input connected to an input capacitor with the same capacity as the feedback capacitor, and with a grounded resistor and a balancing resistor to present oscillation. This circuit is effective for obtaining a good linear relationship between its input and output voltage, yet the output accuracy is not constant owing to the influence of varying basic component characteristics of a capacitor and a resistor. The applicant proposes a method to improve the capacitance accuracy by locating unit capacitors at random in Japanese Patent Laid-Open Publication No. 8-102522 (the second conventional embodiment).

Even when such measures are taken, the capacitors actually formed in the integrated semiconductor circuit system have variable characteristics because of such manufacturing conditions as the temperature, processing time, mask shift and so on.

The deviation cannot be detected from outside of the integrated semiconductor circuit system; therefore, it is difficult to control the outputs accurately.

### SUMMARY OF THE INVENTION

The present invention provides a component characteristics measurement circuit in integrated semiconductor circuit system which is possible to detect characteristics invariability.

The component characteristics measurement circuit in an integrated semiconductor circuit system of the present invention has the structure that an input impedance and a feedback impedance are connected to an inverting amplifying circuit consisting of an odd number of stages of inverters. Enough impedance units are connected to make one of them the reference impedance and another the measurement object, known voltage is input to the inverting amplifying circuit, and its output is measured from the outside of the integrated semiconductor circuit system.

### BRIEF DESCRIPTION OF THE DRAWINGS

FIG. 1 shows a block diagram of an exemplary embodiment of a circuit according to the present invention.

FIG. 2 shows a circuit of the CMOS inverter in the embodiment in FIG. 1.

FIG. 3 shows a circuit of the reference capacitor of the embodiment in FIG. 1.

FIG. 4 shows the reference voltage generating circuit in the embodiment.

FIG. 5 shows a circuit of the first variation of the reference capacitor in the embodiment.

FIG. 6 shows a circuit of the second variation of the reference capacitor in the embodiment.

FIG. 7 shows the circuit of the reference resistor in the embodiment.

FIG. 8 shows a circuit of the first variation of the reference resistor in the embodiment.

FIG. 9 shows a circuit of the second variation of the reference resistor in the embodiment.

### PREFERRED EMBODIMENT OF THE PRESENT INVENTION

Hereinafter, an embodiment of the component characteristics measurement circuit according to the present invention is described with reference to the attached drawings.

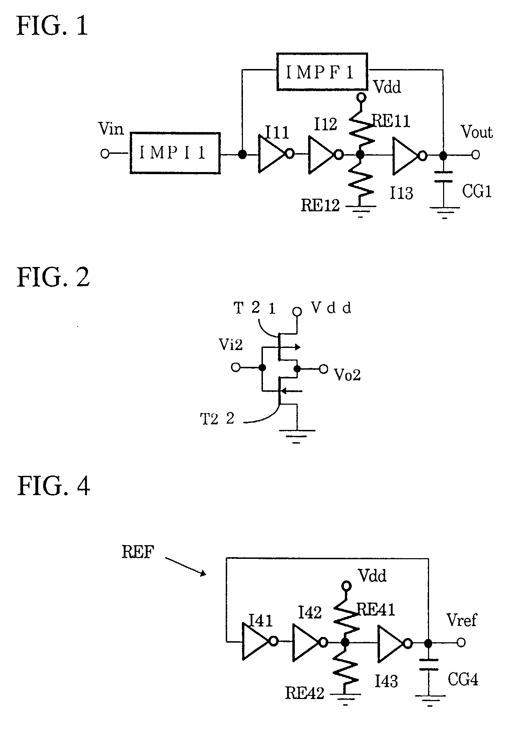

FIG. 1 shows an embodiment of the component characteristics measurement circuit. In this circuit, the output of the inverting amplifying circuit in which an odd number of stages of CMOS inverters I11, I12 and I13 are serially connected is connected to its input through feedback impedance IMPF1, and input impedance IMPI1 is also connected to the input of the inverting amplifying circuit.

Assuming that the input voltage of the component characteristics measurement circuit is Vin, the output voltage is Vout, and the offset voltage of the CMOS inverter is Vb, the relationship between the input and output is shown in formula (1):

$$Vout\text{-}Vb = -\frac{IMPF1}{IMPI1}(Vin\text{-}Vb) \qquad (1)$$

When IMPI1 in formula (1) is the measurement object, IMPF1 is structured to be the reference impedance, and when IMPF1 is that object, IMPI1 is the reference impedance. The reference impedance is realized by locating unit capacitors of the second embodiments at random.

As I11 to I13 are similarly structured, only I11 is described. As shown in FIG. 2, pMOS transistor T21 and nMOS transistor T22 are serially connected between supply voltage Vdd and the ground, input voltage Vi2 is connected to both transistor gates, and output voltage Vo2 is output from both transistor drains.

The output of the last-stage MOS inverter I13 in the component measurement circuit is connected to the ground through grounded capacitor CG1 which reduces the high-frequency factors. The output of the middle MOS inverter I12 is connected to Vdd and the ground through a pair of balancing resistors RE11 and RE12, respectively. These resistors become the load to control the open loop-gain of the inverting amplifying circuit. This structure prevents oscillation of the inverting amplifying circuit including its feedback system.

Various structures can be the reference impedance: in an integrated semiconductor circuit system, generally, these are a capacitor, resistor or their complex circuit. Rather many components structure the reference impedance.

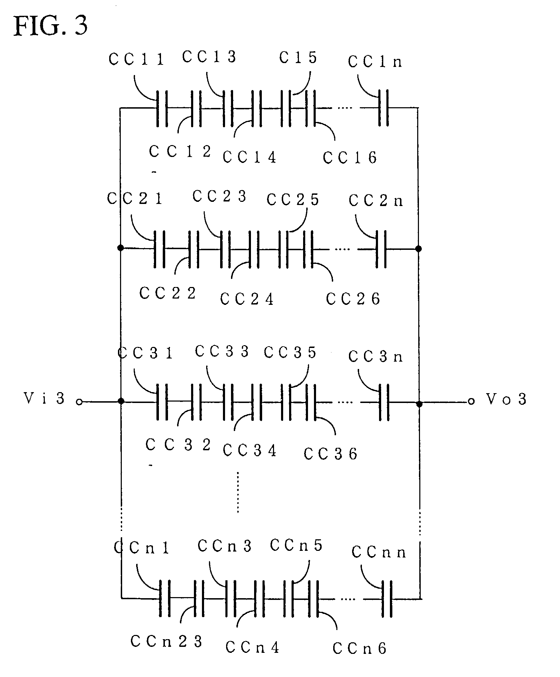

In FIG. 3, the reference impedance includes n number of capacitor couples having n number of capacitors of (CC11, CC12, ...CC1n), (CC21, CC22, ...CC2n), ...(CCn1, CCn2, ...CCnn), the capacitors in each couple are serially connected, and these serial circuits are parallelly connected. The value of capacitor Ct, consisting of a plurality of circuit blocks sequentially connected for parallel processing, is shown in formula (2):

$$Ct = \sum_{i=1}^{n} \frac{1}{\sum_{j=1}^{n} \frac{1}{CCij}} \qquad (2)$$

When the value of each capacitor is equal (CCij=CC=constant), formula (3) is derived from formula (2):

$$Ct=CC \qquad (3)$$

CC in formula (3) adopts the minimum capacitance actually formed in an integrated semiconductor circuit system, for example. Such a circuit, consisting of a plurality of circuit blocks sequentially connected for parallel processing, can realize, any magnitude of capacitance as a multiple of proper number of unit capacitors.

Each unit capacitor is arrayed at random similar to the second conventional embodiment so that the characteristics do not incline. Supposing that the value of the reference capacitor is CCr and the impedance to be measured is the same as the value of unit capacitor CC, when the impedance to be measured is assigned to the input capacitor value, formula (4) is feasible:

$$Vout\text{-}Vb = - \frac{CC}{CCr} (Vin\text{-}Vb) \qquad (4)$$

And when the impedance to be measured is assigned to the feedback capacitor value, formula (5) is feasible:

$$Vout\text{-}Vb = - \frac{CCr}{CC} (Vin\text{-}Vb) \qquad (5)$$

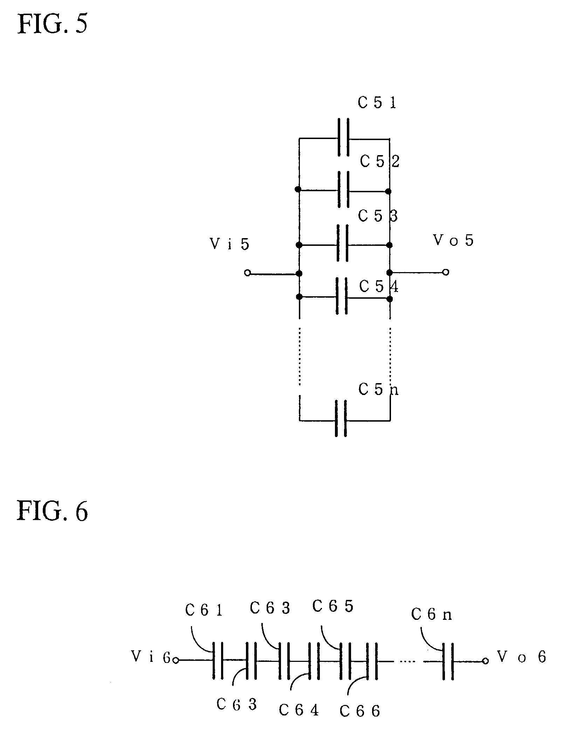

Vin is the known voltage supplied from outside, and Vout can be measured from outside. Vb is the voltage equivalent to Vref, which is the output of reference voltage generating circuit REF in FIG. 4. Vref also can be measured from outside.

In REF of FIG. 4, CMOS inverters I41, I42 and I43 are serially connected in three stages, and the output is connected to the input. The output Vref of this circuit converges to the offset voltage Vb, at which the input and output voltages are equal. Further in REF, grounded capacitor CG4 and balancing resistors RE41 and RE42 are connected, which function as in the circuit in FIG. 1 to prevent oscillation.

In the above configuration, the ratio of CC to CCr can be calculated by measuring Vout.

FIGS. 5 and 6 show circuits which form the reference impedance by capacitors in parallel and serial array, respectively. In the parallel circuit in FIG. 5, Ct is as in formula (6):

$$Ct = \sum_{i=1}^{n} C5i \qquad (6)$$

It is as in formula (7) in the serial circuit in FIG. 6:

$$Ct = \frac{1}{\sum_{i=1}^{n} \frac{1}{C6i}} \qquad (7)$$

Assuming the capacity of each component to be CC, formulas (6) and (7) can be transformed into (8) and (9), respectively:

$$Ct=nCC \qquad (8)$$

$$Ct = \frac{CC}{n} \qquad (9)$$

When Ct values in formulas (8) and (9) are used instead of CCr, the characteristic deviation can be measured, similarly.

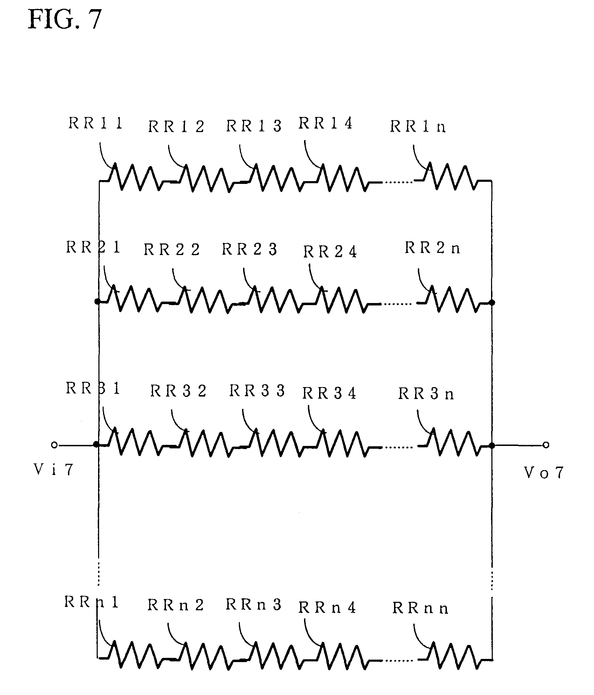

In FIG. 7, the reference impedance includes n number of resistor couples having n number of resistors (RR11, RR12, ...RR1n), (RR21, RR22, ...RR2n), ...(RRn1, RRn2, ...RRnn), the resistors in each couple are serially connected, and these serial circuits are parallelly connected. The value of resistor Rt, which consists of a plurality of circuit blocks sequentially connected for parallel processing, is shown in formula (10):

$$Rt = \frac{1}{\sum_{i=1}^{n} \frac{1}{\sum_{j=1}^{n} RRij}} \qquad (10)$$

When the value of each resistor is equal (RRij=RR=constant), formula (11) is derived from formula (10):

$$Rt=RR \qquad (11)$$

RR in formula (11) adopts the minimum resistance actually formed in an integrated semiconductor circuit system, for example. Such a circuit, consisting of a plurality of circuit blocks sequentially connected for parallel processing, can realize any value of resistor as a multiple of the proper number of unit resistors.

Each unit capacitor is arrayed in random similar to the second conventional embodiment so that the characteristics do not incline. Supposing that the value of the reference resistor is RRr and the impedance to be measured is the unit resistor RR, when the impedance to be measured is set to the input resistor value, formula (12) is feasible:

$$Vout\text{-}Vb = -\frac{RR}{RRr}(Vin\text{-}Vb) \qquad (12)$$

And when the impedance to be measured is set to the feedback resistor value, formula (13) is feasible:

$$Vout\text{-}Vb = -\frac{RRr}{RR}(Vin\text{-}Vb) \qquad (13)$$

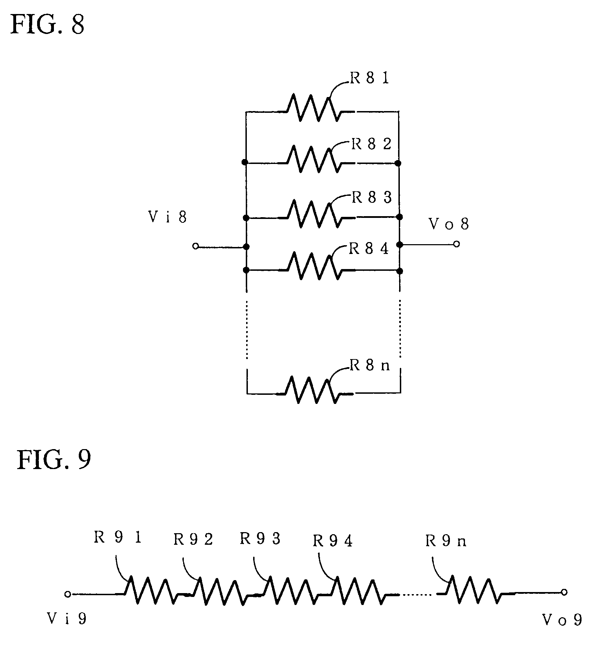

FIGS. 8 and 9 show circuits which form the reference impedance by resistors in parallel and serial array, respectively. In the parallel circuit in FIG. 8, Rt is as in formula (14):

$$Rt = \frac{1}{\displaystyle\sum_{i=1}^{n} \frac{1}{R8i}} \qquad (14)$$

It is as in formula (15) in the serial circuit in FIG. 5:

$$Rt = \sum_{i=1}^{n} R9i \qquad (15)$$

Assuming the resistor value of each component to be RR, formulas (14) and (15) can be transformed into (16) and (17), respectively:

$$Rt = \frac{RR}{n} \qquad (16)$$

$$Rt = nRR \qquad (17)$$

When Rt values in formulas (16) and (17) are used instead of RRr, the characteristic deviation can be measured, similarly.

MOS resistor and MOS capacitor can be used instead of unit resistor and unit capacitor that are mentioned above.

A component characteristics measurement circuit in an integrated semiconductor circuit system according to the present invention can detect the component characteristics deviation in a circuit because it has the structure that an input impedance and a feedback impedance are connected to an inverting amplifying circuit consisting of an odd number of stages of inverters. Enough impedance units are connected to make one of them the reference impedance and another the measurement object, known voltage is input to the inverting amplifying circuit, and its output is measured from the outside of the integrated semiconductor circuit system.

**Claims**

1. A component characteristics measurement circuit in an integrated semiconductor circuit system, comprising:

    i) an inverting amplifying circuit comprising an odd number of stages of serial inverters,
    ii) a feedback capacitor for connecting the output of said inverting amplifying circuit to its input; and
    iii) an input capacitor connected to the input of said inverting amplifying circuit;
    wherein

    a) said input capacitor is connected to known voltage;
    b) an output of said inverting amplifying circuit can be measured from outside;
    c) said input capacitor is that to be measured in said integrated semiconductor circuit system;
    d) said feedback capacitor is made of an enough number of serially connected unit capacitors; and
    e) said unit capacitors are arrayed at random.

2. A component characteristics measurement circuit in an integrated semiconductor circuit system, comprising:

    i) an inverting amplifying circuit comprising an odd number of stages of serial inverters,
    ii) a feedback capacitor for connecting the output of said inverting amplifying circuit to its input; and
    iii) an input capacitor connected to the input of said inverting amplifying circuit,
    wherein

a) said input capacitor is connected to known voltage;

b) an output of said inverting amplifying circuit can be measured from outside;

c) said feedback capacitor is that to be measured in said integrated semiconductor circuit system;

d) said input capacitor is made of an enough number of serially connected unit capacitors; and

e) said unit capacitors are arrayed at random.

3. A component characteristics measurement circuit in an integrated semiconductor circuit system, comprising:

i) an inverting amplifying circuit comprising an odd number of stages of serial inverters;

ii) a feedback capacitor for connecting the output of said inverting amplifying circuit to its input; and

iii) an input capacitor connected to the input of said inverting amplifying circuit; wherein

a) said input capacitor is connected to known voltage;

b) an output of said inverting amplifying circuit can be measured from outside;

c) said input capacitor is that to be measured in said integrated semiconductor circuit system,

d) said feedback capacitor is made of an enough number of parallelly connected unit capacitors; and

e) said unit capacitors are arrayed at random.

4. A component characteristics measurement circuit in an integrated semiconductor circuit system, comprising:

i) an inverting amplifying circuit comprising an odd number of stages of serial inverters,

ii) a feedback capacitor for connecting the output of said inverting amplifying circuit to its input; and

iii) an input capacitor connected to an input of said inverting amplifying circuit; wherein

a) said input capacitor is connected to known voltage;

b) an output of said inverting amplifying circuit can be measured from outside;

c) said input capacitor is that to be measured in said integrated semiconductor circuit system,

d) said input capacitor is made of an enough number of parallelly connected unit capacitors; and

e) said unit capacitors are arrayed at random.

5. A component characteristics measurement circuit in an integrated semiconductor circuit system, comprising:

i) an inverting amplifying circuit comprising an odd number of stages of serial inverters;

ii) a feedback capacitor for connecting the output of said inverting amplifying circuit to its input; and

iii) an input capacitor connected to the input of said inverting amplifying circuit; wherein

a) said input capacitor is connected to known voltage,;

b) an output of said inverting amplifying circuit can be measured from outside;

c) said feedback capacitor is that to be measured in said integrated semiconductor circuit system;

d) said input capacitor that is made of a plurality of parallelly connected circuits in each of which a plurality of unit capacitors are serially connected in the same number as the serial connection number; and

e) said unit capacitors are arrayed at random.

6. A component characteristics measurement circuit in an integrated semiconductor circuit system, comprising:

i) an inverting amplifying circuit comprising an odd number of stages of serial inverters;

ii) a feedback resistor for connecting the output of said inverting amplifying circuit to its input; and

iii) an input resistor connected to the input of said inverting amplifying circuit; wherein

a) said input capacitor is connected to known voltage;

b) an output of said inverting amplifying circuit can be measured from outside,

c) the value of said input resistor is to be measured in said integrated semiconductor circuit system;

d) said feedback resistor is made of an enough number of serially connected unit resistors ; and

e) said unit resistors are arrayed at random.

7. A component characteristics measurement circuit in an integrated semiconductor circuit system, comprising:

i) an inverting amplifying circuit comprising an odd number of stages of serial inverters;
ii) a feedback resistor for connecting the output of said inverting amplifying circuit to its input; and
iii) an input capacitor connected to the input of said inverting amplifying circuit;
wherein

a) said input capacitor is connected to known voltage;
b) an output of said inverting amplifying circuit can be measured from outside;
c) said feedback resistor is that to be measured in said integrated semiconductor circuit system,
d) said input resistor is made of an enough number of parallelly connected unit resistors; and
e) said unit resistors are arrayed at random.

8. A component characteristics measurement circuit in an integrated semiconductor circuit system, comprising:

i) an inverting amplifying circuit comprising an odd number of stages of serial inverters;
ii) a feedback capacitor for connecting the output of said inverting amplifying circuit to its input; and
iii) an input resistor connected to the input of said inverting amplifying circuit;
wherein

a) said input resistor is connected to known voltage;
b) an output of said inverting amplifying circuit can be measured from outside;
c) said input resistor is that to be measured in said integrated semiconductor circuit system;
d) said feedback resistor is made of an enough number of serially connected unit resistors; and
e) said unit resistors are arrayed at random.

9. A component characteristics measurement circuit in an integrated semiconductor circuit system, comprising:

i) an inverting amplifying circuit comprising an odd number of stages of serial inverters;
ii) a feedback resistor for connecting the output of said inverting amplifying circuit to its input; and
iii) an input capacitor connected to the input of said inverting amplifying circuit;
wherein

a) said input capacitor is connected to known voltage;
b) an output of said inverting amplifying circuit can be measured from outside;
c) said feedback resistor is that to be measured in said semiconductor integrated circuit system;
d) said input resistor is made of an enough number of serially connected unit resistors; and
e) said unit resistors are arrayed at random.

10. A component characteristics measurement circuit in an integrated semiconductor circuit system, comprising:

i) an inverting amplifying circuit comprising an odd number of stages of serial inverters;
ii) a feedback resistor for connecting the output of said inverting amplifying circuit to its input; and
iii) an input resistor connected to the input of said inverting amplifying circuit;
wherein

a) said input resistor is connected to known voltage;
b) an output of said inverting amplifying circuit can be measured from outside;
c) said feedback resistor is that to be measured in said semiconductor integrated circuit system;
d) said input resistor that is made of a plurality of parallelly connected circuits in each of which a plurality of unit capacitors are serially connected in the number same as the serial connection number; and
e) said unit capacitors are arrayed at random.

FIG. 1

FIG. 2

FIG. 4

FIG. 3

CC11  CC13    C15    CC1n

CC12  CC14    CC16

CC21    CC23    CC25    CC2n

CC22  CC24    CC26

CC31    CC33  CC35    CC3n

Vi3 o                                    o Vo3

CC32  CC34    CC36

CCn1    CCn3  CCn5    CCnn

CCn23    CCn4      CCn6

FIG. 5

C 5 1

C 5 2

C 5 3

V i 5          V o 5

C 5 4

C 5 n

FIG. 6

C 6 1    C 6 3    C 6 5          C 6 n

V i 6                                    V o 6

C 6 3    C 6 4    C 6 6

FIG. 7

FIG. 8

R 8 1

R 8 2

V i 8

R 8 3

V o 8

R 8 4

R 8 n

FIG. 9

R 9 1    R 9 2    R 9 3    R 9 4        R 9 n

V i 9                                                V o 9

**European Patent Office**

## EUROPEAN SEARCH REPORT

**Application Number**

EP 97 11 9272

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| Y | PATENT ABSTRACTS OF JAPAN vol. 013, no. 269 (P-888), 21 June 1989 & JP 01 061669 A (NEC CORP), 8 March 1989, | 1-5 | H01L27/08 G01R31/316 |
| A | * abstract; figures 1,2 * | 6-10 | |
| Y A | EP 0 707 275 A (YOZAN INC ;SHARP KK (JP)) * page 2, line 17 – page 3, line 3 * * page 4, line 16 – line 24; figures * | 1,2,5 6-10 | |
| Y A | US 5 457 417 A (SHOU GUOLIANG ET AL) * column 1, line 18; claims; figures * * column 2, line 31 – column 3, line 15 * | 3,4 6-10 | |
| Y | PATENT ABSTRACTS OF JAPAN vol. 009, no. 050 (P-339), 5 March 1985 & JP 59 188567 A (NIPPON DENKI KK), 25 October 1984, * abstract * | 6-10 | |
| Y | PATENT ABSTRACTS OF JAPAN vol. 097, no. 002, 28 February 1997 & JP 08 256037 A (SHARP CORP;YOZAN:KK), 1 October 1996, * abstract; figure 3 * | 6-10 | TECHNICAL FIELDS SEARCHED (Int.Cl.6) H01L G01R G06F |
| A | PATENT ABSTRACTS OF JAPAN vol. 096, no. 004, 30 April 1996 & JP 07 336169 A (YOUZAN:KK;OTHERS: 01), 22 December 1995, & US 5 650 752 A (SHOU GUOLIANG ET AL) 22 July 1997 * column 1, line 62 – column 2, line 61 * | 1-10 | |
| A | EP 0 704 904 A (YOZAN INC ;SHARP KK (JP)) | 1-10 | |

The present search report has been drawn up for all claims

| Place of search | Date of completion of the search | Examiner |
|---|---|---|
| THE HAGUE | 13 February 1998 | Wirner, C |

EPO FORM 1503 03.82 (P04C01)